# EUROPEAN PATENT APPLICATION

(11) **EP 4 848 976 A2**
(43) Date of publication of application: **02.12.2026**
(21) Application number: 26167621.7
(22) Date of filing: 25.03.2026
(51) Int. Cl.: H10W 76/12, H05K 7/14

(54) **EXTENSION OF CREEPAGE DISTANCE BETWEEN TERMINALS OF LOW-INDUCTANCE POWER SEMICONDUCTOR MODULES**

(30) Priority: 06.05.2025 US 202563800596 P; 27.06.2025 US 202519252147
(71) Applicant: Infineon Technologies AG, 85579 Neubiberg (DE)
(72) Inventor: NOLTEN, Ulrich, 59602 Rüthen (DE); DITZ, Michael, 59939 Olsberg (DE)
(74) Representative: Westphal, Mussgnug & Partner, Patentanwälte mbB

(57) **Abstract**

A semiconductor module arrangement (500) includes a housing (502) having an electrically insulative enclosure (504), an electrical terminal (506) with a first contact surface (508) exposed outside the enclosure, and another electrical terminal (510) with a second contact surface (512) below the first contact surface and exposed outside the enclosure. The contact surfaces are laterally spaced from one another by a creepage surface region (514) of the enclosure that determines a creepage distance between the contact surfaces. The creepage surface region includes a recess (516) in the enclosure having a first sidewall (518) closer to the first contact surface, a second sidewall (520) closer to the second contact surface, and ridges (522) between the sidewalls. A distance between adjacent ridges, between the first sidewall and the ridge closest to the sidewall, and between the second sidewall and the ridge closest to the sidewall are greater than or equal to a specified minimum dimension for increasing creepage for a predetermined pollution degree.

## Description

### CROSS-REFERENCE TO RELATED APPLICATION

This application is a Continuation Application of U.S. Provisional Application No. 63/800,596, filed May 6, 2025.

### TECHNICAL FIELD

The instant disclosure relates to a housing for a semiconductor module.

### BACKGROUND

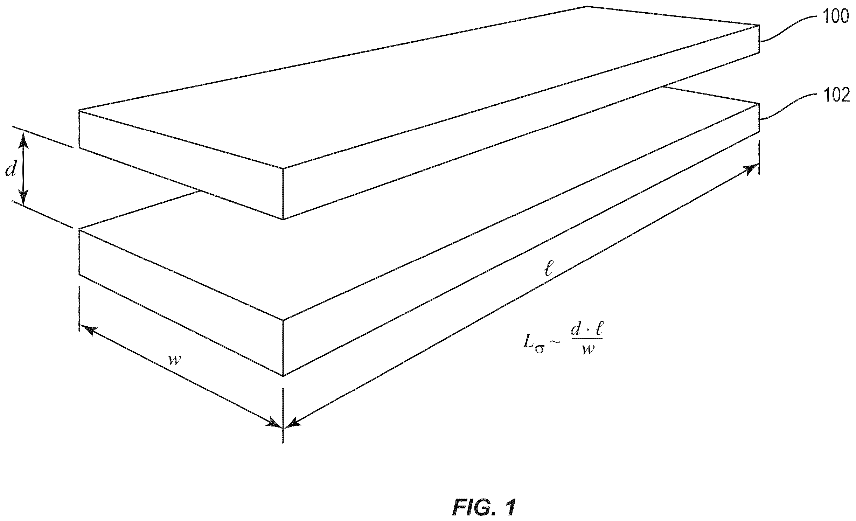

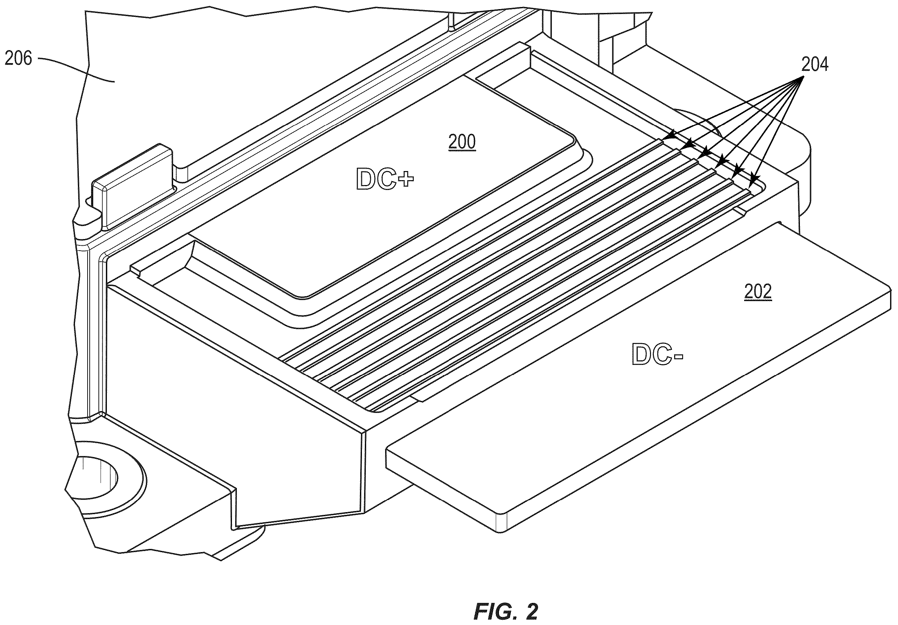

The realization of low inductive power modules requires that the busbars for DC+ (positive DC potential) and DC- (negative DC potential) are placed in close contact. From FIG. 1, it can be seen that the distance 'd' between two broadside coupled conductors 100, 102 influences the stray inductance L_{σ} significantly, and becomes smaller as the distance 'd' decreases. This can be realized by solid insulation consisting of a plastic housing material between the two terminals 100, 102 in power modules. To also allow a low-inductive connection of the module to the customer system, the terminals 200, 202 for laser welding connection of customer busbars in the configuration shown in FIG. 2 have proven to offer the lowest stray inductance in the inverter system.

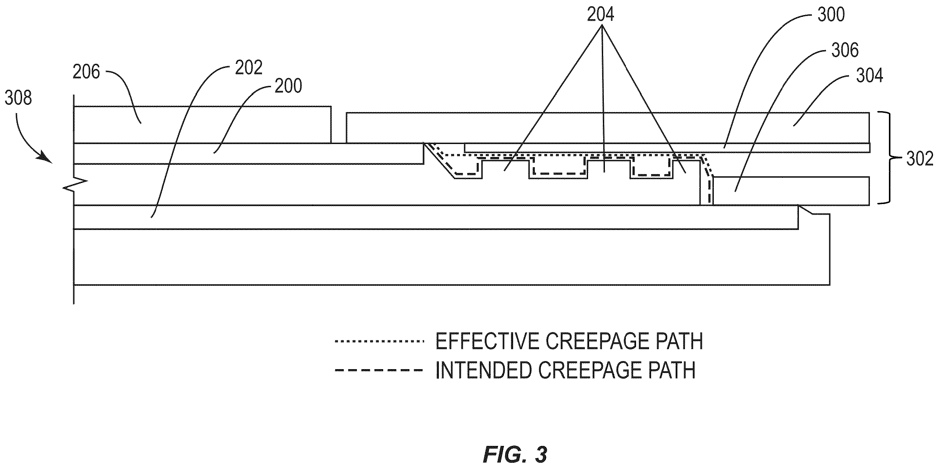

Despite the low inductance design, the requirements for insulation coordination (e.g., defined by the standard IEC standard 60664-1) have to be considered in the housing design between the power terminals 200, 202. To have a low stray inductance L_{σ} in the system and not to create unnecessarily large modules, the distance between the two terminal connection points for the customer should be minimized. The minimum value is given by the required clearance. If the creepage is excessive, ribs 204 on the housing 206 are used to enlarge the creepage distance over the surface of the module, as shown with the 'intended creepage path' distance in FIG. 3. But if a tracking material like the insulation material 300 of the customer busbar arrangement 302 with corresponding planar busbars 304, 306 is too close to the module 308, the creepage path changes to the shown 'effective creepage path' and leads to an unacceptable shortening of the creepage distance.

There is a need for a housing that increases a creepage distance along a housing while maintaining a needed clearance between the housing and a busbar arrangement mounted to the housing.

### SUMMARY

According to an embodiment of a semiconductor module arrangement, the semiconductor module arrangement comprises: a housing comprising an electrically insulative enclosure, a first electrical terminal having a first contact surface exposed outside the enclosure, and a second electrical terminal having a second contact surface below the first contact surface and exposed outside the enclosure, wherein the first and the second contact surfaces are laterally spaced from one another by a creepage surface region of the enclosure that determines a creepage distance between the first and the second contact surfaces, wherein the creepage surface region comprises a recess in the enclosure having a first sidewall closer to the first contact surface, a second sidewall closer to the second contact surface, and a plurality of ridges between the first and the second sidewalls, wherein a distance between adjacent ones of the ridges, between the first sidewall and the ridge closest to the first sidewall, and between the second sidewall and the ridge closest to the second sidewall are greater than or equal to a specified minimum dimension for increasing creepage for a predetermined pollution degree.

According to another embodiment of a semiconductor module arrangement, the semiconductor module arrangement comprises: a housing comprising an electrically insulative enclosure, a first electrical terminal having a first contact surface exposed outside the enclosure, and a second electrical terminal having a second contact surface below the first contact surface and exposed outside the enclosure, wherein the first and the second contact surfaces are laterally spaced from one another by a creepage surface region of the enclosure that determines a creepage distance between the first and the second contact surfaces, wherein the creepage surface region comprises a recess in the enclosure having a first sidewall closer to the first contact surface and a second sidewall closer to the second contact surface; and an electrically insulative material disposed in the recess and having a higher CTI (comparative tracking index) than the enclosure.

According to an embodiment of a semiconductor module arrangement, the semiconductor module arrangement comprises: a housing comprising: a first electrical terminal comprising a first contact surface; a second electrical terminal comprising a second contact surface below and laterally spaced from the first contact surface; a creepage surface positioned between the first and second electrical terminals and having one end nearer to the first electrical terminal than a second end, the second end being nearer to the second electrical terminal than the first end; a lip positioned at an end of the creepage surface closer to the second terminal than the first terminal, and extending upward from the creepage surface; and a plurality of ribs extending upwardly from the creepage surface between the first and second ends, the ribs having a height h1 and the lip having a height greater than h1 by a distance h2.

Those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a partial side perspective view of a busbar arrangement having first and second planar busbars.
FIG. 2 illustrates a partial side perspective view of a semiconductor module arrangement.
FIG. 3 illustrates a partial cross-sectional view of a semiconductor module arrangement.
FIG. 4 illustrates a partial cross-sectional view of the outer surface of an electrically insulative enclosure of a semiconductor module arrangement.
FIG. 5 illustrates a partial side perspective view of a semiconductor module arrangement.
FIG. 6 illustrates a partial cross-sectional view of the semiconductor module arrangement of FIG. 5, in the area of a creepage surface region of the module enclosure.
FIG. 7 illustrates a cross-sectional view of the creepage surface region of the module enclosure, according to another embodiment.

### DETAILED DESCRIPTION

Embodiments described herein increase (elongate) the creepage distance between two low-inductive terminals of a semiconductor module arrangement by providing small ribs, also referred to herein as ridges, and/or a high CTI (comparative tracking index) material in a main groove, also referred to herein as recess, formed in the electrically insulative enclosure of the module housing, without shortening the creepage path over the insulation of the customer busbar arrangement.

The ridges are formed in a creepage surface region of the module enclosure. The creepage surface region includes a recess in the module enclosure having a first sidewall closer to an exposed contact surface of a first electrical terminal and a second sidewall closer to an exposed contact surface of a second electrical terminal below the first terminal, with the ridges between the sidewalls. The distance between adjacent ones of the ridges, between the first sidewall and the ridge closest to the first sidewall, and between the second sidewall and the ridge closest to the second sidewall are greater than or equal to a specified minimum dimension for increasing creepage for a predetermined pollution degree, e.g., as defined in IEC standard 60664-1 published by the IEC (international electrotechnical commission).

Separately, or in combination with the ridges, the high CTI material is an electrically insulative material disposed in the recess of the creepage surface region and having a higher CTI than the module enclosure. In either case (ridges or high CTI material), or in both cases combined (ridges and high CTI material), the creepage distance between the exposed contact surfaces of the module terminals is not reduced (shortened) by attaching a customer busbar arrangement to the exposed contact surfaces of the terminals.

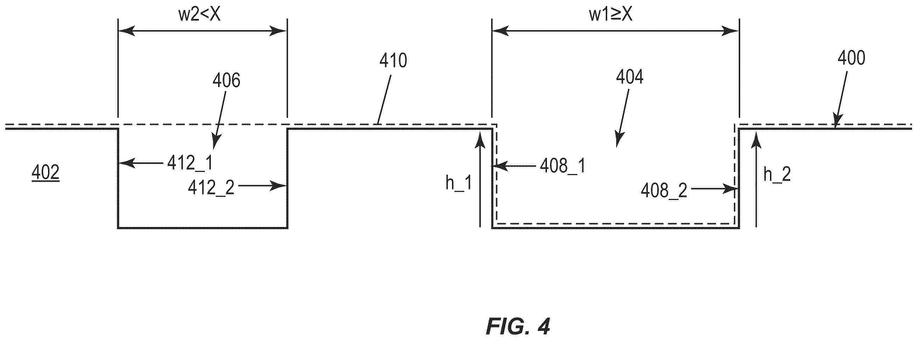

Creepage distances can be elongated (increased) by ridges and recesses formed on the surface of an electrically insulative enclosure (e.g., plastic housing) of a semiconductor module arrangement, if the ridges and recesses follow certain rules as defined by an industry standard that defines creepage requirements. A significant rule is defined in the standard IEC 60664-1, which requires a groove (recess) to have a minimum width 'x' to be considered as a creepage distance elongation, as shown in FIG. 4.

FIG. 4 shows part of an outer surface 400 of an electrically insulative enclosure 402 of a semiconductor module arrangement. Two (2) grooves / recesses 404, 406 are shown formed in the outer surface 400 of the enclosure 402. The enclosure 402 may be, e.g., a plastic housing and the grooves / recesses 404, 406 may be formed during the molding process that produces the plastic housing. The grooves / recesses 404, 406 instead may be formed in the outer surface 400 after the enclosure 402 is produced, e.g., by etching, stamping, cutting, grinding, etc. The width or distance 'w1' between opposing first and second sidewalls 408_1, 408_2 of the first groove / recess 404 formed in the outer surface 400 of the enclosure 402 is greater than or equal to a specified minimum dimension 'x' for increasing creepage for a predetermined pollution degree (of the environment). Accordingly, the creepage path 410 follows the contour of the first groove / recess 404 as indicated by the corresponding portion of the dashed line in FIG. 4, which increases the overall creepage distance by the combined height (h_1 + h_2) of the first and second sidewalls 408_1, 408_2 of the first groove / recess 404.

In one embodiment, the specified minimum dimension 'x' is defined in IEC standard 60664-1 published by the IEC for various pollution degrees. For pollution degree 1, there is no pollution, or only dry, nonconductive pollution. For pollution degree 2, the environment can temporarily become conductive from occasional condensation. For pollution degree 3, the environment is subject to conductive pollution, or nonconductive pollution that can become conductive from expected condensation. For pollution degree 4, continuous conductivity occurs from conductive dust, rain or other wet conditions. The actual value of the specified minimum dimension 'x' depends not only on the pollution degree but also the material group of the insulating material that forms the electrically insulative enclosure 402 (e.g., material group I, II or III as defined in IEC standard 60664-1 published by the IEC).

The width or distance 'w2' between opposing first and second sidewalls 412_1, 412_2 of the second groove / recess 406 formed in the outer surface 400 of the enclosure 402 is less than the specified minimum dimension 'x' for increasing creepage for a predetermined pollution degree. Accordingly, the creepage path 410 bridges the second groove / recess 406 as indicated by the corresponding portion of the dashed line in FIG. 4 and instead only follows the enclosure (not the recess) contour.

The same rule can also be considered if the creepage path traverses multiple parts. In this case, the creepage path traverses the module housing and can jump to the insulation of the customer busbar arrangement, if the gap is smaller than the specified minimum dimension 'x' for increasing creepage for a predetermined pollution degree. An example is shown in FIG. 3, where the intention was to guide the creepage path over the housing with the ribs 204 for elongation of the creepage path ('intended creepage path'). However, when the insulation material 300 of the customer busbar arrangement 302 is positioned near the module housing, the effective creepage path bridges the ribs 204 and instead traverses straight over the insulation material 300 of the customer busbar arrangement 302 ('effective creepage path').

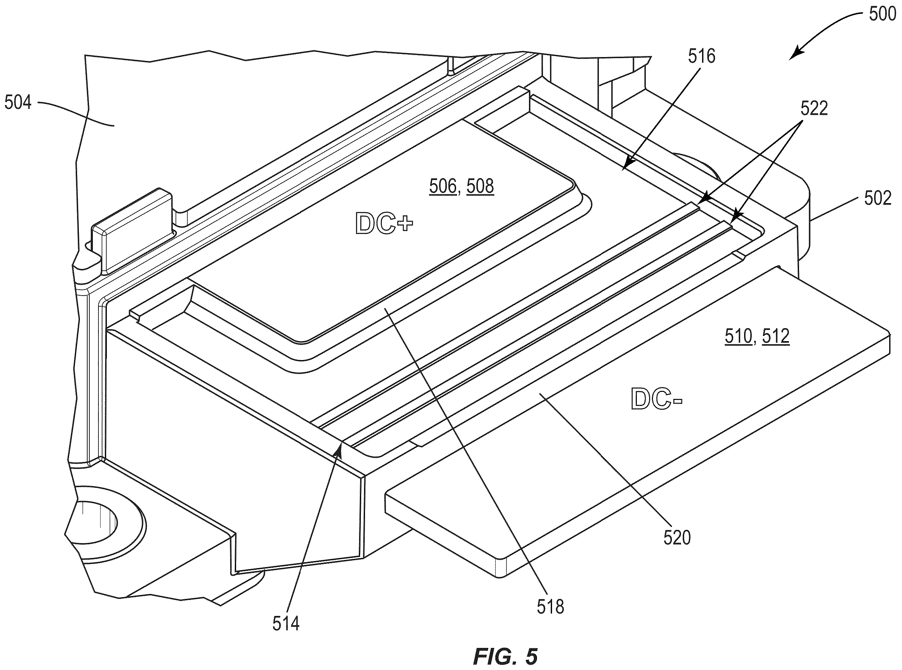

FIG. 5 illustrates a partial side perspective view of an embodiment of a semiconductor module arrangement 500. The semiconductor module arrangement 500 includes a housing 502 that comprises an electrically insulative enclosure 504, a first electrical terminal 506 having a first contact surface 508 exposed outside the enclosure 504, and a second electrical terminal 510 having a second contact surface 512 below the first contact surface 508 and exposed outside the enclosure 504. The electrical terminals 506, 510 may be busbars, substrates with metallization (e.g., printed circuit board or ceramic substrate with metallization), etc. The terminals 506, 510 provide points of external electrical contact via respective contact surfaces 508, 512 exposed outside the enclosure 504, and carry corresponding electrical power signals (e.g., DC+ and DC-) inside the enclosure 504 to one or more power semiconductor devices (out of view) housed in the enclosure 504.

The semiconductor devices form all or part of a power circuit, such as a DC/AC inverter, a DC/DC converter, an AC/DC converter, a DC/AC converter, an AC/AC converter, a multi-phase inverter, an H-bridge, motor driver, etc. In some examples, the circuit is a half-bridge or full-bridge circuit. The semiconductor devices may be, e.g., SiC transistor dies such as SiC power MOSFET (metal-oxide-semiconductor field-effect transistor) dies, Si power MOSFET dies, HEMT (high-electron mobility transistor) dies, IGBT (insulated-gate bipolar transistor) dies, JFET (junction filed-effect transistor) dies, etc. The semiconductor devices may be attached to one or more substrates housed in the enclosure 504, e.g., such as a DCB (direct copper bonded) or AMB (active metal brazed) substrate, printed circuit board (PCB), lead frame, insulated metal substrate (IMS), etc.

As explained above, the first and second electrical terminals 506, 510 carry corresponding electrical power signals inside the enclosure 504 to the one or more power semiconductor devices housed in the enclosure 504, and as such are also referred to herein as power terminals. For example, one of the power terminals 506, 510 is at a positive DC potential (DC+) and the other one of the power terminals 506, 510 is at a negative DC potential (DC-). The power terminals 506, 510 may be vertically stacked one above the other, e.g., as shown in FIG. 1 to reduce stray inductance L_{σ}.

The exposed contact surfaces 508, 512 of the power terminals 506, 510 are laterally spaced from one another by a creepage surface region 514 of the module enclosure 504. The creepage surface region 514 determines the creepage distance between the first and the second contact surfaces 508, 512 of the power terminals 506, 510.

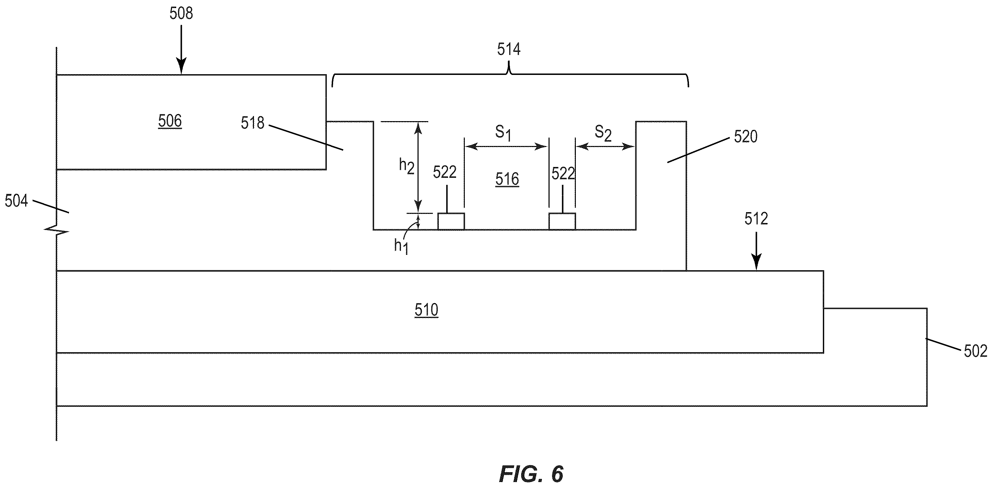

FIG. 6 illustrates a partial cross-sectional view of the semiconductor module arrangement 500, in the area of the creepage surface region 514 of the module enclosure 504. The creepage surface region 514 includes a recess (groove) 516 formed in the module enclosure 504. The recess 516 has a first sidewall 518 closer to the first contact surface 508 than the second contact surface 512, a second sidewall 520 closer to the second contact surface 512 than the first contact surface 508, and ridges 522 between the first and the second sidewalls 518, 520. The module enclosure 504 may be a plastic housing and the recess 516 and the ridges 522 may be formed during the molding process that produces the plastic housing. The recess 516 and the ridges 522 instead may be formed after the enclosure 504 is produced, e.g., by etching, stamping, cutting, grinding, etc.

In either case, the distance S1 between adjacent ones of the ridges 522 and the distance S2 between each sidewall 518, 520 and the closest ridge 522 are greater than or equal to the specified minimum dimension 'x' for increasing creepage for a predetermined pollution degree. A busbar arrangement, such as that shown in FIG. 1 or FIG. 3, may be connected to the power terminals 506, 510 of the module 502 such that one busbar is connected to the first (upper) power terminal 506 and another busbar is connected to the second (lower) power terminal 510. For example, the busbar arrangement 302 may include first and second planar busbars 304, 306 as shown in FIG. 3. The first busbar 304 may be connected to the exposed contact surface 508 of the first power terminal 506, with the first busbar 304 extending generally parallel to the creepage surface region 514 of the module enclosure 504. The second busbar 306 may be connected to the exposed contact surface 512 of the second power terminal 510.

As shown in FIG. 3, the busbar arrangement 302 may further include an electrical insulator 300 separating the first and second planar busbars 304, 306. Upon attaching the busbar arrangement 302 to the power terminals 506, 510 of the module housing 502, the electrical insulator 300 is vertically spaced from and at least partly overlaps the creepage surface region 514 of the module enclosure 504. The distance S1 between adjacent ones of the ridges 522 and the distance S2 between each sidewall 518, 520 of the recess 516 and the closest ridge 522 are such that the creepage distance between the exposed contact surfaces 508, 512 of the power terminals 506, 510 excludes the electrical insulator 300 of the busbar arrangement 302. With such a configuration, the creepage path with the busbar arrangement 302 attached to the power terminals 506, 510 of the module housing 502 would follow the 'intended creepage path' in FIG. 3 and not the 'effective creepage path'.

The required clearance between the module power terminals 506, 510 defines the required spacing. If the creepage requirement is longer, the recess 516 may be formed in the housing enclosure 504 with a generally planar creepage (bottom) surface and an upwardly extending lip (sidewall) 520 at the right end of the housing 502 in FIGS. 5 and 6. Furthermore, ribs (ridges) 522 are implemented on the creepage surface of the recess 516 to further enlarge the creepage distance. The physical distance between the module power terminals 506, 510 can in this way be minimized, significantly reducing the stray inductance L_{σ}.

As explained above, FIG. 6 shows how the proposed ridges 522 should be designed in accordance with this disclosure. At first, the distance S1 between adjacent ridges 522 and the distance S2 between the right sidewall 520 and the closest ridge 522 at the right end of the creepage surface region 514 must be larger than the specified minimum dimension 'x' for increasing creepage for a predetermined pollution degree, e.g., as specified in the standard IEC-60664-1, such that the creepage path does not bridge the recess 516 formed in the module enclosure 504.

The height h1 of the ridges 522, measured from the creepage (bottom) surface of the recess 516 to the top surface of the ridges 522, is needed to enlarge the creepage distance for each ridge 522 by 2*h1. The distance h2 between the top surface of the ridges 522 and the top surface of the enclosure 504 between the exposed contact surfaces 508, 512 of the module power terminals 506, 510 has to be greater than a specified minimum height difference for ensuring the creepage distance between the first and the exposed contact surfaces 508, 512 remains unchanged. That is, the ridges 522 have a height h1 and the sidewalls 518, 520 of the recess 516 have a height greater than h1 by a distance h2. This ensures that the creepage path will not 'jump' or bridge to an insulation of a customer busbar arrangement and then shorten (reduce) the creepage path. The specified minimum height difference may be the same value as the specified minimum dimension 'x' for increasing creepage for a predetermined pollution degree, e.g., as specified in the standard IEC-60664-1.

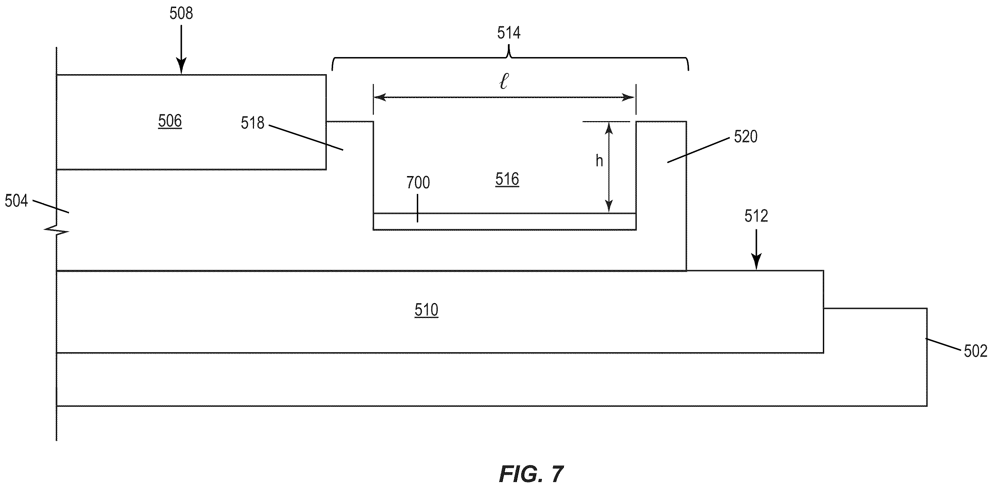

FIG. 7 illustrates a cross-sectional view of the creepage surface region 514 of the module enclosure 504, according to another embodiment. In FIG. 7, an electrically insulative material 700 is disposed in the recess 516. The electrically insulative material 700 has a higher CTI (comparative tracking index) than the module enclosure 504, and as such is also referred to herein as higher CTI material. For example, the electrically insulative material 700 may comprise a silicone gel, an epoxy, a polyimide, a mold compound, etc. with a higher CTI than the material of the module enclosure 504.

In one embodiment, the bottom of the recess 516 is filled with the higher CTI material 700. The higher CTI material 700 forms a cemented joint with the material of the enclosure 504 in the recess 516. The cemented joint may be formed by glue, an adhesive, a locally melted region of the higher CTI material 700 and the enclosure material, etc., such that the resulting creepage path traverses the top surface of the higher CTI material 700 and not along the interface with the enclosure material on the bottom side. The elongation of the creepage distance may be reached as follows. If the creepage path traverses a mixture of materials, there are two possibilities to calculate the creepage distance:
(1) the whole creepage distance is designed with the lowest CTI of all involved materials; or
(2) a part of the creepage distance showing a high CTI has to take up the whole voltage for the design of the creepage distance.

The latter option is exploited in FIG. 7. In one embodiment, the higher CTI material 700 is classified in material group I as defined in IEC standard 60664-1 published by the IEC and the material of the enclosure 504 is classified in material group II or III as defined in IEC standard 60664-1 published by the IEC. If the material of the enclosure 504 is classified in material group III as defined in IEC standard 60664-1 published by the IEC, the distance 'I' between the opposing sidewalls 518, 520 of the recess 516 may be more than 50% of the creepage distance between the exposed second contact surfaces 508, 512 of the power terminals 506, 510, to ensure that the creepage distance is enlarged (increased). The same advantage applies for material combinations between material classes (groups) II and III as well as for material classes (groups) I and II, but with different percentage values of the partial creepage distance having the higher CTI.

In FIG. 7, the ridges 522 are omitted from the creepage surface region 514 of the module enclosure 504. However, this is merely an option. The ridges 522 instead may be included in the creepage surface region 514, with the higher CTI material 700 covering the ridges 522 in the bottom of the recess 516. In another embodiment, the module enclosure 504 may include two (2) or more separate creepage surface regions 514 for increasing the creepage distance between the exposed contact surfaces 508, 512 of the module power terminals 506, 508. One creepage surface region 514 may include the ridges 522 but not the higher CTI material 700, and another creepage surface region 514 may include the higher CTI material 700 but not the ridges 522. A third creepage surface region 514 may include both the ridges 522 and the higher CTI material 700 covering the ridges 522.

The creepage surface region embodiments described herein enable system voltage scaling up to 1500V or higher, e.g., to serve the emerging 'megawatt charging' trend in e-Trucks.

Although the present disclosure is not so limited, the following numbered examples demonstrate one or more aspects of the disclosure.

Example 1. A semiconductor module arrangement, comprising: a housing comprising an electrically insulative enclosure, a first electrical terminal having a first contact surface exposed outside the enclosure, and a second electrical terminal having a second contact surface below the first contact surface and exposed outside the enclosure, wherein the first and the second contact surfaces are laterally spaced from one another by a creepage surface region of the enclosure that determines a creepage distance between the first and the second contact surfaces, wherein the creepage surface region comprises a recess in the enclosure having a first sidewall closer to the first contact surface, a second sidewall closer to the second contact surface, and a plurality of ridges between the first and the second sidewalls, wherein a distance between adjacent ones of the ridges, between the first sidewall and the ridge closest to the first sidewall, and between the second sidewall and the ridge closest to the second sidewall are greater than or equal to a specified minimum dimension for increasing creepage for a predetermined pollution degree.

Example 2. The semiconductor module arrangement of example 1, wherein a height difference between the ridges and the sidewalls is greater than or equal to a specified minimum height difference for ensuring the creepage distance between the first and the second contact surfaces remains unchanged.

Example 3. The semiconductor module arrangement of example 1 or 2, wherein one of the first electrical terminal and the second electrical terminal is at a positive DC potential, and wherein the other one of the first electrical terminal and the second electrical terminal is at a negative DC potential.

Example 4. The semiconductor module arrangement of any of examples 1 through 3, wherein a distance between the first and the second sidewalls of the recess is more than 50% of the creepage distance between the first and the second contact surfaces.

Example 5. The semiconductor module arrangement of any of examples 1 through 4, further comprising an electrically insulative material disposed in the recess and having a higher CTI (comparative tracking index) than the enclosure.

Example 6. The semiconductor module arrangement of example 5, wherein a height difference between the electrically insulative material disposed in the recess and the sidewalls of the recess is greater than or equal to a specified minimum height difference for ensuring the creepage distance between the first and the second contact surfaces remains unchanged.

Example 7. The semiconductor module arrangement of example 5 or 6, wherein the electrically insulative material forms a cemented joint with the enclosure in the recess.

Example 8. The semiconductor module arrangement of any of examples 5 through 7, wherein the electrically insulative material is classified in material group I as defined in IEC standard 60664-1 published by the IEC (international electrotechnical commission), and wherein the enclosure is classified in material group II or III as defined in IEC standard 60664-1 published by the IEC.

Example 9. The semiconductor module arrangement of example 8, wherein the enclosure is classified in material group III as defined in IEC standard 60664-1 published by the IEC, and wherein a distance between the first and the second sidewalls of the recess is more than 50% of the creepage distance between the first and the second contact surfaces.

Example 10. The semiconductor module arrangement of any of examples 1 through 9, further comprising: a busbar arrangement comprising first and second planar busbars, wherein the first busbar is connected to the first electrical terminal, wherein the second busbar is connected to the second electrical terminal, and wherein the first busbar extends generally parallel to the creepage surface region of the enclosure.

Example 11. The semiconductor module arrangement of example 10, wherein the busbar arrangement further comprises an electrical insulator separating the first and second planar busbars, wherein the electrical insulator is vertically spaced from and at least partly overlaps the creepage surface region of the enclosure, and wherein the distance between adjacent ones of the ridges, between the first sidewall and the ridge closest to the first sidewall, and between the second sidewall and the ridge closest to the second sidewall are such that the creepage distance between the first and the second contact surfaces excludes the electrical insulator.

Example 12. A semiconductor module arrangement, comprising: a housing comprising an electrically insulative enclosure, a first electrical terminal having a first contact surface exposed outside the enclosure, and a second electrical terminal having a second contact surface below the first contact surface and exposed outside the enclosure, wherein the first and the second contact surfaces are laterally spaced from one another by a creepage surface region of the enclosure that determines a creepage distance between the first and the second contact surfaces, wherein the creepage surface region comprises a recess in the enclosure having a first sidewall closer to the first contact surface and a second sidewall closer to the second contact surface; and an electrically insulative material disposed in the recess and having a higher CTI (comparative tracking index) than the enclosure.

Example 13. The semiconductor module arrangement of example 12, wherein a height difference between the electrically insulative material disposed in the recess and the sidewalls of the recess is greater than or equal to a specified minimum height difference for ensuring the creepage distance between the first and the second contact surfaces remains unchanged.

Example 14. The semiconductor module arrangement of example 12 or 13, wherein the electrically insulative material forms a cemented joint with the enclosure in the recess.

Example 15. The semiconductor module arrangement of any of examples 12 through 14, wherein the electrically insulative material is classified in material group I as defined in IEC standard 60664-1 published by the IEC (international electrotechnical commission), and wherein the enclosure is classified in material group II or III as defined in IEC standard 60664-1 published by the IEC.

Example 16. The semiconductor module arrangement of example 15, wherein the enclosure is classified in material group III as defined in IEC standard 60664-1 published by the IEC, and wherein a distance between the first and the second sidewalls of the recess is more than 50% of the creepage distance between the first and the second contact surfaces.

Example 17. The semiconductor module arrangement of any of examples 12 through 16, further comprising: a busbar arrangement comprising first and second planar busbars, wherein the first busbar is connected to the first electrical terminal, wherein the second busbar is connected to the second electrical terminal, and wherein the first busbar extends generally parallel to the creepage surface region of the enclosure.

Example 18. The semiconductor module arrangement of example 17, wherein the busbar arrangement further comprises an electrical insulator separating the first and second planar busbars, wherein the electrical insulator is vertically spaced from and at least partly overlaps the creepage surface region of the enclosure, and wherein the distance between the sidewalls of the recess and a height difference between the electrically insulative material disposed in the recess and the sidewalls of the recess are such that the creepage distance between the first and the second contact surfaces excludes the electrical insulator.

Example 19. A semiconductor module arrangement, comprising: a housing comprising: a first electrical terminal comprising a first contact surface; a second electrical terminal comprising a second contact surface below and laterally spaced from the first contact surface; a creepage surface positioned between the first and second electrical terminals and having one end nearer to the first electrical terminal than a second end, the second end being nearer to the second electrical terminal than the first end; a lip positioned at an end of the creepage surface closer to the second terminal than the first terminal, and extending upward from the creepage surface; and a plurality of ribs extending upwardly from the creepage surface between the first and second ends, the ribs having a height h1 and the lip having a height greater than h1 by a distance h2.

Example 20. The semiconductor module arrangement of example 19, further comprising: a busbar arrangement comprising first and second planar busbars, the first busbar being connected to the first electrical terminal, and the second busbar being connected to the second electrical terminal, wherein the first busbar extends generally parallel to the creepage surface.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to cover all possible conjunctive and disjunctive combinations, unless expressly noted otherwise. For example, the expression "A and/or B" should be interpreted to mean A but not B, B but not A, or both A and B. The expression "at least one of" should be interpreted in the same manner as "and/or", unless expressly noted otherwise. For example, the expression "at least one of A and B" should be interpreted to mean A but not B, B but not A, or both A and B.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor module arrangement (500), comprising:
a housing (502) comprising an electrically insulative enclosure (504), a first electrical terminal (506) having a first contact surface (508) exposed outside the enclosure (504), and a second electrical terminal (510) having a second contact surface (512) below the first contact surface (508) and exposed outside the enclosure (504),
wherein the first and the second contact surfaces (508, 512) are laterally spaced from one another by a creepage surface region (514) of the enclosure (504) that determines a creepage distance between the first and the second contact surfaces (508, 512),
wherein the creepage surface region (514) comprises a recess (516) in the enclosure (504) having a first sidewall (518) closer to the first contact surface (508), a second sidewall (520) closer to the second contact surface (512), and a plurality of ridges (522) between the first and the second sidewalls (518, 520),
wherein a distance between adjacent ones of the ridges (522), between the first sidewall (518) and the ridge (522) closest to the first sidewall (518), and between the second sidewall (520) and the ridge (522) closest to the second sidewall (520) are greater than or equal to a specified minimum dimension for increasing creepage for a predetermined pollution degree.

2. The semiconductor module arrangement (500) of claim 1, wherein a height difference between the ridges (522) and the sidewalls (518, 520) is greater than or equal to a specified minimum height difference for ensuring the creepage distance between the first and the second contact surfaces (508, 512) remains unchanged.

3. The semiconductor module arrangement (500) of claim 1 or 2, wherein one of the first electrical terminal (506) and the second electrical terminal (510) is at a positive DC potential, and wherein the other one of the first electrical terminal (506) and the second electrical terminal (510) is at a negative DC potential.

4. The semiconductor module arrangement (500) of any of claims 1 to 3, wherein a distance between the first and the second sidewalls (518, 520) of the recess (516) is more than 50% of the creepage distance between the first and the second contact surfaces (508, 512).

5. The semiconductor module arrangement (500) of any of claims 1 to 4, further comprising an electrically insulative material (700) disposed in the recess (516) and having a higher comparative tracking index, CTI, than the enclosure (504).

6. The semiconductor module arrangement (500) of claim 5, wherein a height difference between the electrically insulative material (700) disposed in the recess (516) and the sidewalls (518, 520) of the recess (516) is greater than or equal to a specified minimum height difference for ensuring the creepage distance between the first and the second contact surfaces (508, 512) remains unchanged.

7. The semiconductor module arrangement (500) of claim 5 or 6, wherein the electrically insulative material (700) forms a cemented joint with the enclosure (504) in the recess (516).

8. The semiconductor module arrangement (500) of any of claims 5 to 7, wherein the electrically insulative material (700) is classified in material group I as defined in IEC standard 60664-1 published by the IEC (international electrotechnical commission), and wherein the enclosure (504) is classified in material group II or III as defined in IEC standard 60664-1 published by the IEC.

9. The semiconductor module arrangement (500) of claim 8, wherein the enclosure (504) is classified in material group III as defined in IEC standard 60664-1 published by the IEC, and wherein a distance between the first and the second sidewalls (518, 520) of the recess (516) is more than 50% of the creepage distance between the first and the second contact surfaces (508, 512).

10. The semiconductor module arrangement (500) of any of claims 1 to 9, further comprising:
a busbar arrangement (302) comprising first and second planar busbars (304, 306),
wherein the first busbar (304) is connected to the first electrical terminal (506),
wherein the second busbar (306) is connected to the second electrical terminal (510), and
wherein the first busbar (304) extends generally parallel to the creepage surface region (514) of the enclosure (504).

11. The semiconductor module arrangement (500) of claim 10, wherein the busbar arrangement (302) further comprises an electrical insulator (300) separating the first and second planar busbars (304, 306), wherein the electrical insulator (300) is vertically spaced from and at least partly overlaps the creepage surface region (514) of the enclosure (504), and wherein the distance between adjacent ones of the ridges (522), between the first sidewall (518) and the ridge closest to the first sidewall (518), and between the second sidewall (520) and the ridge (522) closest to the second sidewall (520) are such that the creepage distance between the first and the second contact surfaces (508, 512) excludes the electrical insulator (300).

12. A semiconductor module arrangement (500), comprising:
a housing (502) comprising an electrically insulative enclosure (504), a first electrical terminal (506) having a first contact surface (508) exposed outside the enclosure (504), and a second electrical terminal (510) having a second contact surface (512) below the first contact surface (508) and exposed outside the enclosure (504), wherein the first and the second contact surfaces (508, 512) are laterally spaced from one another by a creepage surface region (514) of the enclosure (504) that determines a creepage distance between the first and the second contact surfaces (508, 512), wherein the creepage surface region (514) comprises a recess (516) in the enclosure (504) having a first sidewall (518) closer to the first contact surface (508) and a second sidewall (520) closer to the second contact surface (512); and
an electrically insulative material (700) disposed in the recess (516) and having a higher comparative tracking index, CTI, than the enclosure (504).

13. The semiconductor module arrangement (500) of claim 12, wherein a height difference between the electrically insulative material (700) disposed in the recess (516) and the sidewalls (518, 520) of the recess (516) is greater than or equal to a specified minimum height difference for ensuring the creepage distance between the first and the second contact surfaces (508, 512) remains unchanged.

14. A semiconductor module arrangement (500), comprising:
a housing (502) comprising:
a first electrical terminal (506) comprising a first contact surface (508);
a second electrical terminal (510) comprising a second contact surface (512) below and laterally spaced from the first contact surface (508);
a creepage surface (514) positioned between the first and second electrical terminals (506, 510) and having one end nearer to the first electrical terminal (506) than a second end, the second end being nearer to the second electrical terminal (510) than the first end;
a lip (520) positioned at an end of the creepage surface (514) closer to the second terminal (510) than the first terminal (506), and extending upward from the creepage surface (514); and
a plurality of ribs (522) extending upwardly from the creepage surface (514) between the first and second ends, the ribs (522) having a height h1 and the lip (520) having a height greater than h1 by a distance h2.

15. The semiconductor module arrangement (500) of claim 14, further comprising:
a busbar arrangement (302) comprising first and second planar busbars (304, 306), the first busbar (304) being connected to the first electrical terminal (506), and the second busbar (306) being connected to the second electrical terminal (510),
wherein the first busbar (304) extends generally parallel to the creepage surface (514).
